# EUROPÄISCHE PATENTANMELDUNG

(11) **EP 2 036 999 A1**
(43) Veröffentlichungstag der Anmeldung: **18.03.2009**
(21) Anmeldenummer: 08164200.1
(22) Anmeldetag: 12.09.2008
(51) Int. Cl.: C23C 14/08, C23C 14/54, C23C 28/00

(54) **Verfahren zur Herstellung einer Wärmedämmschicht und Wärmedämmschicht**

(30) Priorität: 13.09.2007 DE 102007043791
(71) Anmelder: MTU Aero Engines GmbH, 80995 München (DE)
(72) Erfinder: Jakimov, Andreas, 80997, München (DE); Cosack, Thomas, 86949, Windach (DE)

(57) **Zusammenfassung**

Die vorliegende Erfindung betrifft ein Verfahren zur Verfahren zur Herstellung einer keramischen Wärmedämmschicht auf einem Bauteil zur Verwendung in Verdichter- und Turbinenkomponenten mittels eines Dampfablagerungsverfahrens, wobei das Verfahren folgende Schritte umfasst: a) Bereitstellung eines Keramikdampfs zur Ablagerung auf dem Bauteil; b) Ablagerung des Keramikdampfs auf dem Bauteil zur Ausbildung einer säulen- oder stängelartig strukturierten Wärmedämmschicht, wobei die Säulen oder Stängel im Wesentlichen senkrecht zu einer Bauteiloberfläche ausgerichtet sind; und c) Variierung von mindestens einem Verfahrensparameter während des Verfahrensschritts b), derart, dass die resultierende Wärmedämmschicht Säulen oder Stängel umfasst, die abwechselnd sich verkleinernde und sich vergrößernde Durchmesser aufweisen. Die Erfindung betrifft weiterhin eine Wärmedämmschicht für Bauteile zur Verwendung in Verdichter- und Turbinenkomponenten, wobei die Wärmedämmschicht aus einer säulen- oder stängelartig strukturierten keramischen Wärmedämmschicht besteht und die Säulen oder Stängel im Wesentlichen senkrecht zu einer Bauteiloberfläche ausgerichtet sind. Erfindungsgemäß weisen die Säulen oder Stängel abwechselnd sich verkleinernde und sich vergrößernde Durchmesser auf.

## Beschreibung

Die vorliegende Erfindung betrifft ein Verfahren zur Herstellung einer keramischen Wärmedämmschicht auf einem Bauteil zur Verwendung in Verdichter- und Turbinenkomponenten mittels eines Dampfablagerungsverfahrens sowie eine Wärmedämmschicht für Bauteile zur Verwendung in Verdichter- und Turbinenkomponenten, wobei die Wärmedämmschicht üblicherweise aus einer säulen- oder stängelartig strukturierten keramischen Wärmedämmschicht besteht und die Säulen oder Stängel im Wesentlichen senkrecht zu einer Bauteiloberfläche ausgerichtet sind. Die Erfindung betrifft weiterhin ein Bauteil zur Verwendung in Verdichter- und Turbinenkomponenten bestehend aus einem metallischen Substrat und einer auf das metallische Substrat zumindest teilweise aufgebrachten Wärmedämmschicht.

Aus dem Stand der Technik sind verschiedene Verfahren zur Herstellung einer keramischen Wärmedämmschicht auf Bauteilen, insbesondere zur Verwendung in Verdichter- und Turbinenkomponenten, bekannt. Dabei wird eine Keramikschicht entweder durch ein Plasmaspritzverfahren oder mittels physikalischem Dampfablagerungsverfahren (PVD) auf das Bauteil aufgebracht. Durch die Verwendung von physikalischen Dampfablagerungsverfahren, insbesondere auch der Elektronenstrahlbedampfung (EB-PVD), entstehen Keramikschichten mit stängel- oder säulenförmigen Strukturen. Die Säulen bzw. Stängel weisen dabei über ihre Länge eine konstante Dicke auf. Auch eine säulenartige Unterstruktur der Säulen bzw. Stängel ist homogen. Derartig hergestellte keramische Wärmedämmschichten haben gegenüber den durch einen thermischen Spritzprozess hergestellten Wärmedämmschichten den Vorteil, dass sie infolge der Säulenstruktur eine verbesserte Thermowechselbeständigkeit aufweisen. Zudem lassen die einzelnen Stängeln oder Säulen ein Ausdehnen und Zusammenziehen des Stängelgefüges zu, ohne dass es zu Spannungen kommt, die im Extremfall zum Abplatzen einzelner Teile der Wärmedämmschicht führen können. Durch das zusätzliche Auftragen von wärmedämmenden Keramikschichten auf die genannten Bauteile wird die Bauteilwerkstofftemperatur erniedrigt und damit die Festigkeit erhalten. Als keramischer Werkstoff wird dabei meistens Zirkoniumoxid mit verschiedenen Stabilisatoren, insbesondere Yttriumoxid, verwendet. Verfahren zur Herstellung keramischer Wärmedämmschichten und entsprechende Wärmedämmschichten für metallische Bauteile zur Verwendung in Verdichter- und Turbinenkomponenten sind aus der DE 601 03 526 T2, der DE 693 18 856 T2 sowie den US-Patentschriften Nr. 4,321,311 A, 4,401,697 A, 4,405,659 A sowie 5,514,482 bekannt.

Nachteilig an den bekannten Verfahren zur Herstellung von keramischen Wärmedämmschichten sowie den daraus hergestellten Wärmedämmschichten ist jedoch, dass durch die Verwendung von physikalischen Dampfablagerungsverfahren relativ dichte säulen- bzw. stängelartige Strukturen entstehen. Die relativ hohe Dichte begünstigt jedoch nachteiligerweise den Wärmefluss innerhalb der keramischen Wärmedämmschicht.

Es ist daher Aufgabe der vorliegenden Erfindung eine gattungsgemäße Wärmedämmschicht für ein Bauteil mit einer insbesondere deutlich reduzierten Wärmeleitfähigkeit bereitzustellen.

Es ist weiterhin Aufgabe der vorliegenden Erfindung ein gattungsgemäßes Verfahren zur Herstellung einer keramischen Wärmedämmschicht bereitzustellen, bei dem die resultierende Wärmedämmschicht eine deutliche, insbesondere reduzierte Wärmeleitfähigkeit aufweist.

Zudem ist es weitere Aufgabe der vorliegenden Erfindung ein Bauteil zur Verwendung in Verdichter- und Turbinenkomponenten bestehend aus einem metallischen Substrat und einer auf das metallische Substrat zumindest teilweise aufgebrachten Wärmedämmschicht bereitzustellen, wobei die Wärmedämmschicht eine gegenüber bekannten Wärmedämmschichten, insbesondere deutlich, reduzierte Wärmeleitfähigkeit aufweist.

Gelöst werden diese Aufgaben durch ein Verfahren gemäß den Merkmalen des Anspruchs 1, eine Wärmedämmschicht gemäß den Merkmalen des Anspruchs 16 sowie ein Bauteil gemäß den Merkmalen des Anspruchs 22.

Vorteilhafte Ausgestaltungen der Erfindung sind in den jeweiligen Unteransprüchen beschrieben.

Ein erfindungsgemäßes Verfahren zur Herstellung einer keramischen Wärmedämmschicht auf einem Bauteil zur Verwendung in Verdichter- und Turbinenkomponenten umfasst ein Dampfablagerungsverfahren mit folgenden Verfahrensschritten: a) Bereitstellung eines Keramikdampfs zur Ablagerung auf dem Bauteil; b) Ablagerung des Keramikdampfs auf dem Bauteil zur Ausbildung einer säulen- oder stängelartig strukturierten Wärmedämmschicht, wobei die Säulen oder Stängel im Wesentlichen senkrecht zu einer Bauteiloberfläche ausgerichtet sind; und c) Variierung von mindestens einem Verfahrensparameter während des Verfahrensschritts b), derart, dass die resultierende Wärmedämmschicht Säulen oder Stängel umfasst, die unterschiedliche Geometrien, insbesondere abwechselnd sich verkleinernde und sich vergrößernde Durchmesser, aufweisen. Erfindungsgemäß umfasst der Keramikdampf bzw. das Keramikmaterial Zirkon- bzw. Zirkoniumoxid und A₂O₃, wobei das A in A₂O₃ aus einer Gruppe ausgewählt ist, welche Er, Nd, Yb, Eu, Dy Gd, Sc, La, Al und Pr umfasst. Es kann in bevorzugter Weiterbildung vorgesehen sein, dass der Keramikdampf bzw. das Keramikmaterial Zirkon- bzw. Zirkoniumoxid und eine Mischung von wenigstens zwei Oxiden aus einer Gruppe von Oxiden umfasst, welche Gruppe Er₂O₃, Nd₂O₃, Yb₂O₃, Eu₂O₃, Dy₂O₃, Gd₂O₃, Sc₂O₃ , La₂O₃ , Al₂O₃ und Pr₂O₃ umfasst bzw. welche Gruppe Oxide von Er, Oxide von Nd, Oxide von Yb, Oxide von Eu, Oxide von Dy, Oxide von Gd, Oxide von Sc, Oxide von Al, Oxide von La und Oxide von Pr umfasst.

Bei dem Dampfablagerungsverfahren handelt es sich insbesondere um ein physikalisches Dampfablagerungsverfahren, wie zum Beispiel ein Elektronenstrahl-Dampfablagerungsverfahren. Es ist jedoch auch denkbar ein Kathodenzerstäubungsverfahren oder ein Lichtbogenverdampfungsverfahren sowie CVD-Verfahren einzusetzen. Durch die Verwendung eines Dampfablagerungsverfahrens ist gewährleistet, dass die entstehende Wärmedämmschicht säulen- oder stängelartig strukturiert ist und somit bereits bekannte Vorteile derartig strukturierter keramischer Wärmedämmschichten erhalten bleiben. Erfindungsgemäß weisen die entstehenden Säulen oder Stängel unterschiedliche Geometrien, insbesondere abwechselnd sich verkleinernde und sich vergrößernde Durchmesser, auf.

Durch die sich abwechselnd verkleinernden und vergrößernden Durchmesser im Laufe der Schichtentstehung der Wärmedämmschicht entstehen Poren zwischen den einzelnen Säulen oder Stängeln, die zu einer deutlichen Reduzierung des Wärmeflusses und damit der Wärmeleitfähigkeit der entstehenden Wärmedämmschicht beitragen. Das Merkmal der sich verkleinernden und vergrößernden Durchmesser ist dabei insbesondere auch so zu verstehen, dass sich benachbarte Säulen bzw. Stängel zumindest abschnittsweise über ihre Länge nicht berühren und nicht parallel verlaufen. Selbiges gilt für eine eventuell auftretende Unterstruktur. Zudem verhindern vorteilhafterweise die kleinen Durchmesser der einzelnen Stängel oder Säulen den Wärmefluss massiv, so dass es auch dadurch zu einer erheblichen Reduzierung der Wärmeleitfähigkeit der entstehenden Wärmedämmschicht kommt.

In weiteren vorteilhaften Ausgestaltungen des erfindungsgemäßen Verfahrens wird das Verfahren in einer Beschichtungskammer, insbesondere einer Vakuumkammer, durchgeführt. Dabei wird das zu beschichtende Bauteil in die Beschichtungskammer eingeführt und die keramische Wärmedämmschicht darauf abgelagert. Das Bauteil wird üblicherweise zumindest an der zu beschichteten Bauteiloberfläche erwärmt bzw. erhitzt.

Zudem ist es möglich, dass während des Verfahrensschritts b) Sauerstoff und Inertgas zugeleitet werden und die Variierung von mindestens einem Verfahrensparameter während des Verfahrensschritts c) die Variierung des Partialdrucks von Sauerstoff und/oder dem Inertgas während der Beschichtung oder in der Beschichtungskammer umfasst. Dabei können die Partialdrücke und auch der Gesamtdruck über die Gasflüsse oder die Pumpleistung geregelt werden.
Es ist aber auch möglich, dass während des Verfahrensschritts b) das zu beschichtende Bauteil bewegt wird und die Variierung von mindestens einem Verfahrensparameter während des Verfahrensschritts c) die Variierung der Art der Bauteilbewegung und/oder Bauteilgeschwindigkeit während der Beschichtung umfasst. Dabei kann das Bauteil insbesondere rotiert werden, so dass die Variierung von mindestens einem Verfahrensparameter während des Verfahrensschritts c) die Variierung der Drehzahl während der Beschichtung umfasst. Des Weiteren ist es möglich, dass die Variierung von mindestens einem Verfahrensparameter während des Verfahrensschritts c) die Variierung der Abscheiderate des Keramikdampfs auf das Bauteil während der Beschichtung umfasst. Schließlich ist auch eine Variierung des Drucks während der Beschichtung oder in der Beschichtungskammer zur Variierung von mindestens einem Verfahrensparameter während des Verfahrensschritts c) möglich. Durch die genannten Maßnahmen ergibt sich die erfindungsgemäße Schichtstruktur der keramischen Wärmedämmschicht, wobei die entstehenden Säulen oder Stängel unterschiedliche Geometrien, insbesondere abwechselnd sich verkleinernde und sich vergrößernde Durchmesser entlang ihrer Längserstreckung, aufweisen.

Üblicherweise wird die Wärmedämmschicht in einer Dicke zwischen 1 und 400 µm abgelagert, jedoch sind auch andere Schichtdicken denkbar.

In einer weiteren vorteilhaften Ausgestaltung des erfindungsgemäßen Verfahrens wird zwischen der zu beschichtenden Bauteiloberfläche und in der Wärmedämmschicht zumindest teilweise eine Haftschicht ausgebildet. Die Haftschicht kann dabei aus MCrAlY alitierten/Al-angereicherten Oberflächen, oder Pt/Al bestehen. Die Haftschicht kann dabei mittels bekannter thermischer Spritzverfahren, galvanischer-, Diffusionsbehandlungsverfahren oder auch mittels physikalischer Dampfablagerungsverfahren aufgetragen werden. Zudem ist es in einer weiteren Ausgestaltung des erfindungsgemäßen Verfahrens möglich, dass zwischen der zu beschichtenden Bauteiloberfläche und der Haftschicht zumindest teilweise eine Zwischenschicht aus Aluminiumoxid ausgebildet wird.

Eine erfindungsgemäße Wärmedämmschicht besteht aus Keramikmaterial und weist eine säulen- oder stängelartige Struktur bzw. Kornstruktur auf, wobei die Säulen oder Stängel im Wesentlichen senkrecht zu einer Bauteiloberfläche ausgerichtet sind. Erfindungsgemäß weisen die Säulen oder Stängel unterschiedliche Geometrien, insbesondere sich verkleinernde und sich vergrößernde Durchmesser entlang ihrer Längserstreckung, auf. Das Keramikmaterial der Wärmedämmschicht umfasst Zirkon- bzw. Zirkoniumoxid und A₂O₃, wobei das A in A₂O₃ aus einer Gruppe ausgewählt ist, welche Er, Nd, Yb, Eu, Dy, Gd, Sc, La, Al und Pr umfasst. Es kann gemäß einer bevorzugten Weiterbildung vorgesehen sein, dass das Keramikmaterial der Wärmedämmschicht Zirkon- bzw. Zirkoniumoxid und eine Mischung von wenigstens zwei Oxiden aus einer Gruppe von Oxiden umfasst, welche Gruppe Er₂O₃, Nd₂O₃, Yb₂O₃, Eu₂O₃, Dy₂O₃, Gd₂O₃, Sc₂O₃, Al₂O₃, La₂O₃ und Pr₂O₃ umfasst bzw. welche Gruppe Oxide von Er, Oxide von Nd, Oxide von Yb, Oxide von Eu, Oxide von Dy_{,} Oxide von Gd, Oxide von Sc , Oxide von Al, Oxide von La und Oxide von Pr umfasst.

Die Korngrenzen der einzelnen Säulen oder Stängel können sich dabei zumindest teilweise berühren, zwischen den einzelnen Säulen oder Stängeln werden vorteilhafterweise Porenräume ausgebildet. Durch die bevorzugte Weiterbildung der erfindungsgemäßen Struktur bzw. Ausbildung der einzelnen Säulen oder Stängel ergibt sich eine deutliche Reduzierung der Wärmeleitfähigkeit der Wärmedämmschicht, da die kleinen Durchmesser der Einzelstängel den Wärmefluss massiv behindern. Zudem vermindern die innerhalb der Wärmedämmschicht ausgebildeten Poren den Wärmefluss signifikant.

Die Wärmedämmschicht weist üblicherweise eine Dicke zwischen 1 und 400 µm auf, wobei auch andere Dicken denkbar sind.

Ein erfindungsgemäßes Bauteil zur Verwendung in Verdichter- und Turbinenkomponenten besteht aus einem metallischen Substrat und einer auf das metallische Substrat zumindest teilweise aufgebrachten erfindungsgemäßen Wärmedämmschicht, wie im Vorhergehenden beschrieben. Ein entsprechend beschichtetes Bauteil weist aufgrund der deutlichen Reduzierung der Wärmeleitfähigkeit der Wärmedämmschicht gemäß vorliegender Erfindung eine deutlich geringere Verschleißrate bei einer entsprechend höheren Lebensdauer auf.

In weiteren vorteilhaften Ausgestaltungen des erfindungsgemäßen Bauteils kann zwischen dem Substrat und der Wärmedämmschicht zumindest teilweise eine Haftschicht, insbesondere aus MCrAlY und Pt/Al ausgebildet sein. Es ist zudem möglich, dass zwischen dem Substrat und der Haftschicht zumindest teilweise eine Zwischenschicht aus Aluminiumoxid ausgebildet ist. Das erfindungsgemäße Bauteil ist insbesondere Bestandteil eines Gasturbinentriebwerks.

Weitere Vorteile, Merkmale und Einzelheiten der Erfindung ergeben sich aus der nachfolgenden Beschreibung eines zeichnerisch dargestellten Ausführungsbeispiels. Dabei zeigen:
- Fig. 1: eine schematische Schnittdarstellung eines Bauteils mit einer Wärmedämm- schicht gemäß dem Stand der Technik;
- Fig. 2: eine beispielhafte, schematische Schnittdarstellung eines Bauteils mit einer er- findungsgemäßen Wärmedämmschicht;
- Fig. 3: eine weitere, beispielhafte, schematische Schnittdarstellung eines Bauteils mit einer erfindungsgemäßen Wärmedämmschicht; und
- Fig. 4: eine weitere beispielhafte, schematische Schnittdarstellung eines Bauteils mit ei- ner erfindungsgemäßen Wärmedämmschicht.

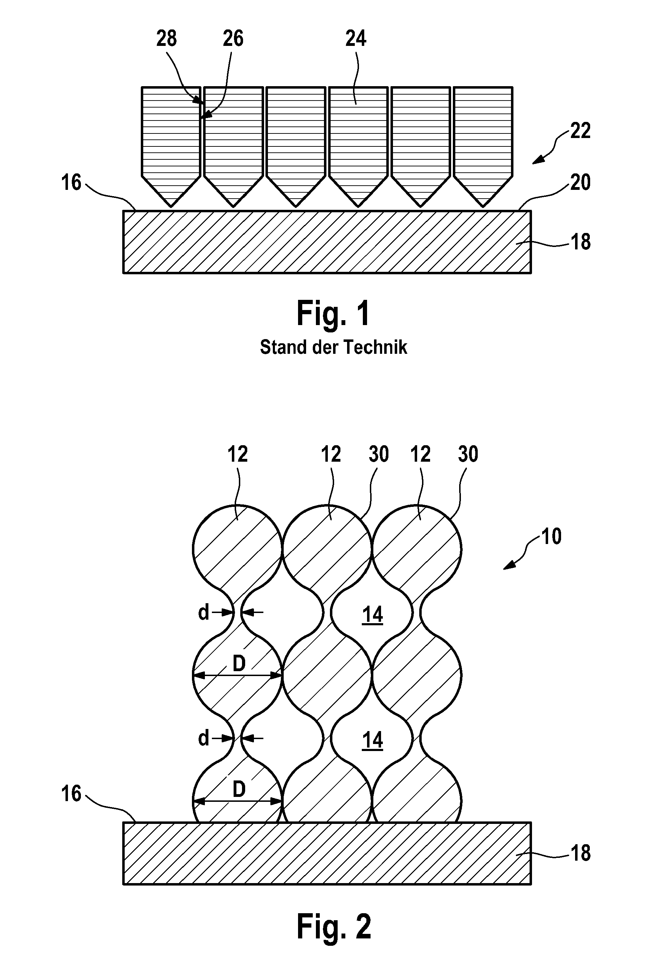

Fig. 1 zeigt in einer schematischen Schnittdarstellung ein Bauteil bzw. ein metallisches Substrat 18 mit einer darauf angeordneten Wärmedämmschicht 22. Zwischen der Wärmedämmschicht 22 und der Bauteiloberfläche 16 ist eine Haftschicht 20, insbesondere aus MCrAlY oder Pt/Al, ausgebildet. Man erkennt, dass die Wärmedämmschicht 22 eine säulen- oder stängelartige Struktur aufweist, wobei die einzelnen Säulen oder Stängel 24 im Wesentlichen senkrecht zu der Bauteiloberfläche 16 ausgerichtet sind. Die Korngrenzen 26, 28 jeweils unterschiedlicher Säulen 24 berühren sich dabei über die Längserstreckung der Stängel 24. Dadurch ergibt sich eine relativ dichte kolumnare Struktur, die den Wärmefluss innerhalb der keramischen Wärmedämmschicht 22 begünstigt.

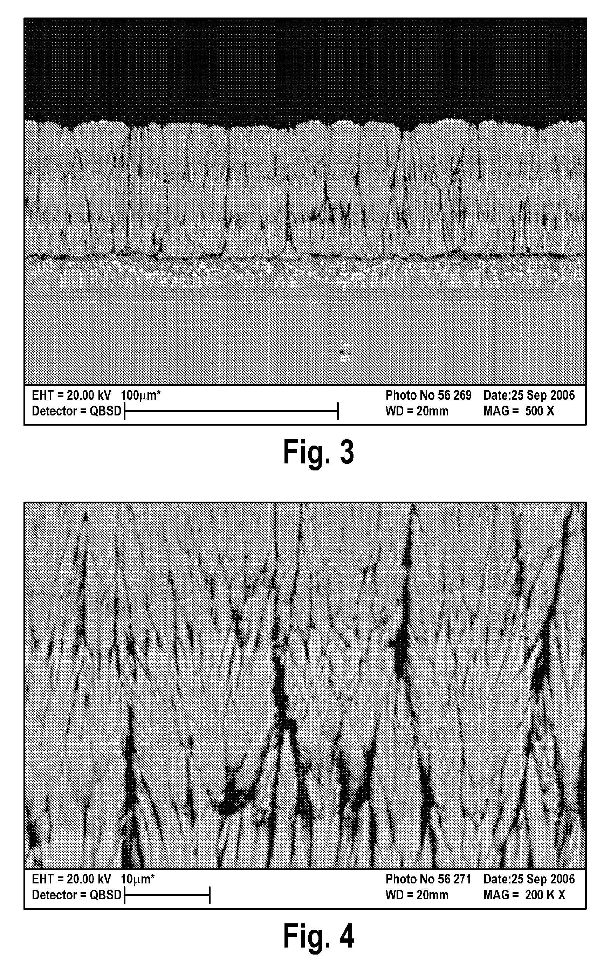

Fig. 2 bis Fig. 4 zeigen jeweils in einer schematischen Schnittdarstellung eine keramische Wärmedämmschicht 10, die auf eine Bauteiloberfläche 16 des Bauteils 18 aufgetragen bzw. dort abgelagert worden ist; anzumerken ist, dass in den Fig. 3 und 4 keine Bezugszeichen eingetragen sind, die dort allerdings in entsprechender Weise gelten. Man erkennt, dass die Wärmedämmschicht 10 wiederum aus Säulen oder Stängeln 12 besteht, die im Wesentlichen senkrecht zu der Bauteiloberfläche 16 ausgerichtet sind. Im Gegensatz zu der in Fig. 1 dargestellten bekannten Säulenstruktur weisen die in Fig. 2 dargestellten Säulen oder Stängel 12 sich abwechselnd verkleinernde und sich vergrößernde Durchmesser d, D - entlang ihrer Längserstreckung - auf. Man erkennt, dass sich die Korngrenzen 30 der einzelnen Stängel zumindest teilweise berühren, jedoch zwischen den einzelnen Säulen oder Stängeln 12 Formräume 14 ausgebildet sind. Durch die kleinen Durchmesser d in den Einzelstängeln oder Einzelsäulen wird der Wärmefluss innerhalb der Wärmedämmschicht 10 massiv behindert. Zudem wird durch die Poren 14 die Dichte der Wärmedämmschicht 10 deutlich verringert, so dass auch hierdurch der Wärmefluss innerhalb der Wärmedämmschicht 10 deutlich verringert wird.

## Patentansprüche

1. Verfahren zur Herstellung einer keramischen Wärmedämmschicht auf einem Bauteil zur Verwendung in Verdichter- und Turbinenkomponenten umfassend ein Dampfablagerungsverfahren mit folgenden Verfahrensschritten:
a) Bereitstellung eines Keramikdampfs zur Ablagerung auf dem Bauteil, wobei der Keramikdampf bzw. das Keramikmaterial Zikonoxid bzw. Zikoniumoxid und A₂O₃ umfasst, wobei das A in A₂O₃ aus einer Gruppe ausgewählt ist, welche Er, Nd, Yb, Eu, Dy, Gd, Sc, La, Al und Pr umfasst;
b) Ablagerung des Keramikdampfs auf dem Bauteil zur Ausbildung einer säulen-oder stängelartig strukturierten Wärmedämmschicht(10), wobei die Säulen oder Stängel (12) im Wesentlichen senkrecht zu einer Bauteiloberfläche (16) ausgerichtet sind; und
c) Variierung von mindestens einem Verfahrensparameter während des Verfahrensschritts b), derart, dass die resultierende Wärmedämmschicht (10) Säulen oder Stängel (12) umfasst, die unterschiedliche Geometrien, insbesondere abwechselnd sich verkleinernde und sich vergrößernde Durchmesser (d, D), aufweisen.

2. Verfahren nach Anspruch 1, **dadurch gekennzeichnet, dass** das Dampfablagerungsverfahren ein physikalisches Dampfablagerungsverfahren (PVD) ist.

3. Verfahren nach Anspruch 2, **dadurch gekennzeichnet, dass** das physikalische Dampfablagerungsverfahren (PVD) ein Elektronenstrahl-Dampfablagerungsverfahren (EB-PVD), ein Kathodenzerstäubungsverfahren oder ein Lichtbogenverdampfungsverfahren ist.

4. Verfahren nach einem der vorhergehenden Ansprüche, **dadurch gekennzeichnet, dass** das Verfahren in einer Beschichtungskammer, insbesondere einer Vakuumkammer durchgeführt wird.

5. Verfahren nach einem der vorhergehenden Ansprüche, **dadurch gekennzeichnet, dass** während des Verfahrensschritts b) Sauerstoff und Inertgas zugeleitet wird und die Variierung von mindestens einem Verfahrensparameter während des Verfahrensschritts c) die Variierung des Partialdrucks von Sauerstoff und/oder dem Inertgas während der Beschichtung oder in der Beschichtungskammer umfasst.

6. Verfahren nach einem der vorhergehenden Ansprüche, **dadurch gekennzeichnet, dass** während des Verfahrensschritts b) das zu beschichtende Bauteil bewegt wird und die Variierung von mindestens einem Verfahrensparameter während des Verfahrensschritts c) die Variierung der Art der Bauteilbewegung und/oder Bauteilgeschwindigkeit während der Beschichtung umfasst.

7. Verfahren nach Anspruch 6, **dadurch gekennzeichnet, dass** das Bauteil rotiert und die Variierung von mindestens einem Verfahrensparameter während des Verfahrensschritts c) die Variierung der Drehzahl während der Beschichtung umfasst.

8. Verfahren nach einem der vorhergehenden Ansprüche, **dadurch gekennzeichnet, dass** die Variierung von mindestens einem Verfahrensparameter während des Verfahrensschritts c) die Variierung der Abscheiderate des Keramikdampfs auf das Bauteil während der Beschichtung umfasst.

9. Verfahren nach einem der vorhergehenden Ansprüche, **dadurch gekennzeichnet, dass** die Variierung von mindestens einem Verfahrensparameter während des Verfahrensschritts c) die Variierung des Drucks während der Beschichtung oder in der Beschichtungskammer umfasst.

10. Verfahren nach einem der vorhergehenden Ansprüche, **dadurch gekennzeichnet, dass** der Keramikdampf bzw. das Keramikmaterial Zikonoxid bzw. zirkoniumoxid und eine Mischung von wenigstens zwei Oxiden aus einer Gruppe von Oxiden umfasst, welche Gruppe von Oxiden Oxide von Er, Oxide von Nd, Oxide von Yb, Oxide von Eu, Oxide von Dy_{,} Oxide von Gd, Oxide von Sc, Oxide von Al, Oxide von La und Oxide von Pr umfasst.

11. Verfahren nach einem der vorhergehenden Ansprüche, **dadurch gekennzeichnet, dass** die Wärmedämmschicht in einer Dicke zwischen 1 und 500 µm abgelagert wird.

12. Verfahren nach einem der vorhergehenden Ansprüche, **dadurch gekennzeichnet, dass** zwischen der zu beschichtenden Bauteiloberfläche (16) und der Wärmedämmschicht (10) zumindest teilweise eine Haftschicht (20) ausgebildet wird.

13. Verfahren nach Anspruch 12, **dadurch gekennzeichnet, dass** die Haftschicht MCrAlY und/oder Pt/Al aufweist oder daraus besteht und/oder Al-angereichert bzw. alitiert ist.

14. Verfahren nach einem der Ansprüche 12 oder 13, **dadurch gekennzeichnet, dass** zwischen der zu beschichtenden Bauteiloberfläche (16) und der Haftschicht (20) zumindest teilweise eine Zwischenschicht aus Aluminiumoxid ausgebildet wird.

15. Verfahren nach einem der vorangehenden Ansprüche, **dadurch gekennzeichnet, dass** der Keramikdampf bzw. das Keramikmaterial weiter wenigstens einen Zusatz aus einer Gruppe von Zusätzen umfasst, welche Gruppe HfO₂, MgO, MnO und ClO₂ sowie Mischungen von zwei oder mehr der vorgenannten Zusätze umfasst.

16. Wärmedämmschicht für Bauteile zur Verwendung in Verdichter- und Turbinenkomponenten, wobei die Wärmedämmschicht aus einer säulen- oder stängelartig strukturierten keramischen Wärmedämmschicht (10) besteht und die Säulen oder Stängel (12) im Wesentlichen senkrecht zu einer Bauteiloberfläche (16) ausgerichtet sind, **dadurch gekennzeichnet, dass** die Säulen oder Stängel (12) abwechselnd sich verkleinernde und sich vergrößernde Durchmesser (d, D) aufweisen, und dass das Keramikmaterial der Wärmedämmschicht (10) A₂O₃ umfasst, wobei das A in A₂O₃ aus einer Gruppe ausgewählt ist, welche Er, Nd, Yb, Eu, Dy Gd und Pr umfasst.

17. Wärmedämmschicht nach Anspruch 16, **dadurch gekennzeichnet, dass** die Korngrenzen der einzelnen Säulen oder Stängel (12) sich zumindest teilweise berühren.

18. Wärmedämmschicht nach Anspruch 16 oder 17, **dadurch gekennzeichnet, dass** zwischen den einzelnen Säulen oder Stängel (12) Porenräume (14) ausgebildet sind.

19. Wärmedämmschicht nach einem der Ansprüche 16 bis 18, **dadurch gekennzeichnet, dass** das Keramikmaterial der Wärmedämmschicht (10) Zirkonoxid und eine Mischung von wenigstens zwei Oxiden aus einer Gruppe von Oxiden umfasst, welche Gruppe Oxide von Er, Oxide von Nd, Oxide von Yb, Oxide von Eu, Oxide von Dy, Oxide von Gd , Oxide von Sc_{,} Oxide von Al_{,} Oxide von La und Oxide von Pr umfasst.

20. Wärmedämmschicht nach einem der Ansprüche 16 bis 19, **dadurch gekennzeichnet, dass** die Wärmedämmschicht (10) eine Dicke zwischen 1 und 500 µm aufweist.

21. Wärmedämmschicht nach einem der Ansprüche 16 bis 20, **dadurch gekennzeichnet, dass** das Keramikmaterial der Wärmedämmschicht (10) weiter wenigstens einen Zusatz aus einer Gruppe von Zusätzen umfasst, welche Gruppe HfO₂, MgO, MnO und ClO₂ sowie Mischungen von zwei oder mehr der vorgenannten Zusätze umfasst.

22. Bauteil zur Verwendung in Verdichter- und Turbinenkomponenten bestehend aus einem metallischen Substrat (18) und einer auf das metallische Substrat (18) zumindest teilweise aufgebrachten Wärmedämmschicht (10) nach einem der Ansprüche 16 bis 21.

23. Bauteil nach Anspruch 22, **dadurch gekennzeichnet, dass** zwischen dem Substrat (18) und der Wärmedämmschicht (10) zumindest teilweise eine Haftschicht (20) ausgebildet ist.

24. Bauteil nach Anspruch 23, **dadurch gekennzeichnet, dass** die Haftschicht (20) aus MCrAlY besteht und/oder Al-angereichert bzw. alitiert ist

25. Bauteil nach Anspruch 23 oder 24, **dadurch gekennzeichnet, dass** zwischen dem Substrat (18) und der Haftschicht (20) zumindest teilweise eine Zwischenschicht aus Aluminiumoxid ausgebildet ist.

26. Bauteil nach einem der Ansprüche 22 bis 25, **dadurch gekennzeichnet, dass** das Bauteil Bestandteil eines Gasturbinentriebwerks ist.
